(19) **Europäisches Patentamt / European Patent Office / Office européen des brevets**

(11) **EP 2 600 416 A2**

(12) # EUROPEAN PATENT APPLICATION
published in accordance with Art. 153(4) EPC

(43) Date of publication:
**05.06.2013 Bulletin 2013/23**

(51) Int Cl.:
*H01L 31/042* (2006.01)  *B05B 1/10* (2006.01)

(21) Application number: **11783788.0**

(22) Date of filing: **19.05.2011**

(86) International application number:
**PCT/KR2011/003727**

(87) International publication number:
**WO 2011/145906 (24.11.2011 Gazette 2011/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.05.2010 KR 20100047014**

(71) Applicant: **Kim, Hee Gon Daejeon 302-120 (KR)**

(72) Inventor: **Kim, Hee Gon Daejeon 302-120 (KR)**

(74) Representative: **Tischner, Oliver Lavoix Munich Bayerstrasse 85a 80335 Munich (DE)**

(54) **WASHING APPARATUS FOR SOLAR CELL MODULE, AND SOLAR CELL MODULE INCLUDING SAME**

(57)  Provided is a washing apparatus for a solar cell module, the washing apparatus, including: a solar cell module which obtains solar energy from sunlight; a watering party which is disposed at an upper end of the solar cell module to sparkle water; a collection party which is disposed at a lower end of the solar cell module to collect the water sparkled from the watering party; a desalination party which desalinates the water collected by the collection party or desalinates rainwater through a catch pit; and a pump which circulates the desalinated water.

Fig. 1

EP 2 600 416 A2

Printed by Jouve, 75001 PARIS (FR)

**Description**

**Technical Field**

The present invention relates to a washing apparatus for a solar cell module, and a solar cell module including the same, and more particularly, to a washing apparatus for a solar cell module, and a solar cell module including the same, which is configured such that the solar cell module is washed by circulating desalinated water in case of rain so that the maximum efficiency of a solar cell can be maintained, and a management cost required for washing the solar cell module can be also reduced.

**Background Art**

In general, a solar cell module is a means for using solar energy for domestic or industrial use in such a manner that a plurality of cells is installed at the outdoor using a frame to receive the solar energy supplied from sunlight and to store it as electrical energy.

Since the solar cell module uses sunlight as an energy source, it becomes a factor that photoelectric conversion efficiency is seriously reduced when a solar cell panel is contaminated by an organic foreign substance including dust. Thus, since it is necessary to prevent it from being contaminated by the organic foreign substance, the solar cell panel should be frequently washed. The reason is because the transmittance of sunlight is reduced even though the pollution of the solar cell panel is insignificant, so the yield efficiency of energy is rapidly reduced.

However, in the case of a conventional solar cell generation in a large capacity, it was installed at lonesome places, so it was neglected in a state of being not washed at many places. Furthermore, in the case of a solar cell module for family use, it was problematic that a management cost is increased due to personnel expenses for washing works because the solar cell panel is washed manually.

**Detailed Description of the Invention**

**Technical Problem**

The present invention has been made keeping in mind the above problems. An aspect of the present invention provides a washing apparatus for a solar cell module, which is configured such that the solar cell module is washed by circulating desalinated water in case of rain so that the photoelectric conversion efficiency of a solar cell can be continually maintained, and a management cost required for washing the solar cell module can be reduced.

Moreover, another aspect of the present invention provides a solar cell module including a washing apparatus for the solar cell module, which is configured such that a surface of the solar cell module is coated with an inorganic paint composition according to the present invention.

**Technical Solution**

According to an aspect of the present invention, there is provided a washing apparatus, including: a solar cell module which obtains solar energy from sunlight; a watering party which is disposed at an upper end of the solar cell module to sprinkle water; a collection party which is disposed at a lower end of the solar cell module to collect the water sprinkled from the watering party; a desalination party which desalinates the water collected by the collection party or desalinates rainwater through a catch pit; and a pump which circulates the desalinated water.

Also, the pump may include a control unit for controlling an operation of the pump.

Furthermore, the pump and the control unit may be operated by a power source supplied from the solar cell module.

Also, when it's cloudy without sunlight or in case of the evening , the pump and the control unit may be operated by a power source supplied a charged storage battery.

Furthermore, the control unit may control an operating time of the pump.

The desalination party may include a drain tube, which enables the desalinated water to have a predetermined water level.

The collection party may include a filter for removing a pollution source from the rainwater and washing water.

Also, the watering party may include another filter for filtering water.

The washing apparatus may further include a removing means for draining off sprinkled water while moving from an upper end to a lower end or moving in left and right directions.

Furthermore, the removing means may remove the sprinkled water by spraying compressed air through a nozzle or may remove the sprinkled water using a wiper and the like.

Also, surfaces of the solar cell module and the desalination party are coated with a hydrophilic inorganic paint composition. The inorganic paint composition may include: alkali metal silicate represented by formulas 1 to 3 below; phosphoric acid ($H_3PO_4$); one or more strong bases selected from the group consisting of KOH, NaOH, LiOH or $LiOH \cdot H_2O$; and water (H2O).

[Formula 1] $xNa_2O \cdot ySiO_2 \cdot nH_2O$

[Formula 2] $xK_2O \cdot ySiO_2 \cdot nH_2O$

[Formula 3] $xLi_2O \cdot ySiO_2 \cdot nH_2O$

In formulas 1 to 3 above, a ratio of x and y is 1 : 1.9 to 500, and n represents a natural number of 1 to 20.

At this time, the inorganic paint composition coated with surfaces of the solar cell module and the desalination party may include: 25 to 95 parts by weight of the alkali metal silicate represented by formulas 1 to 3 above; 0.1 to 1 parts by weight of the phosphoric acid ($H_3PO_4$); 0.5 to 5 parts by weight of the strong bases; and 4 to 74 parts by weight of the water ($H_2O$) with respect to a total weight thereof.

Also, the alkali metal silicate represented by formulas 1 to 3 may be included in the range of 12 to 35 parts by weight, 1 to 15 parts by weight and 12 to 35 parts by weight respectively with respect to the total weight of the inorganic paint composition.

**Advantageous Effects**

According to the present invention, it is advantageous that the solar cell module is washed by circulating the desalinated water in case of rainwater so that the photoelectric conversion efficiency of solar cells can be continuously maintained, and a management cost required for washing the solar cell module can be reduced.

Also, according to the present invention, it is advantageous that an operating time of the pump is controlled by the control unit which is controlled by a power source supplied from the solar cell module so that washing intervals can be controlled according to a pollution level of the solar cell module.

Also, according to the present invention, because the surface of the solar cell module or the surface of the desalination party are coated with the hydrophilic inorganic paint composition, washing efficiency can be maximized at the time of washing using water, and damage of the surface of the solar cell module caused by foreign substances can be minimized. Furthermore, thanks to the coating of the hydrophilic inorganic material, light reflectance and transmittance of the solar cell module can be improved.

**Brief Description of the Drawings**

FIG. 1 is a schematic view showing a washing apparatus for a solar cell module according to the present invention.

FIG. 2 is a schematic view showing a watering party and a collection party illustrated in FIG. 1.

FIG. 3 is a cross-sectional view showing a desalination party illustrated in FIG. 1.

FIG. 4 and FIG. 5 are schematic views showing a removing means for removing water from a solar cell module according to the present invention.

FIG. 6 is a graph showing the measurement results of light reflectance relating to the solar cell module (red rays) coated with a hydrophilic inorganic paint composition according to the present invention and the solar cell module (black rays) not coated with the hydrophilic inorganic paint composition.

FIG. 7 a graph showing the measurement results of light transmittance relating to the solar cell module (red rays) coated with the hydrophilic inorganic paint composition according to the present invention and the solar cell module (black rays) not coated with the hydrophilic inorganic paint composition.

**Best Mode for Carrying Out the Invention**

Hereinafter, preferred embodiments of the present invention will be described in detail with reference to the accompanying drawings. The present invention may, however, be embodied in different forms and should not be construed as limited to the embodiments set forth herein.

The embodiments of the present invention are provided to more specifically explain the present invention to those having ordinary skill in the art to which the present invention pertains. Accordingly, it should be understood that the shape and size of the elements shown in the drawings may be exaggeratedly drawn to provide an easily understood description of the structure of the present invention rather than reflecting the actual sizes of the corresponding elements.

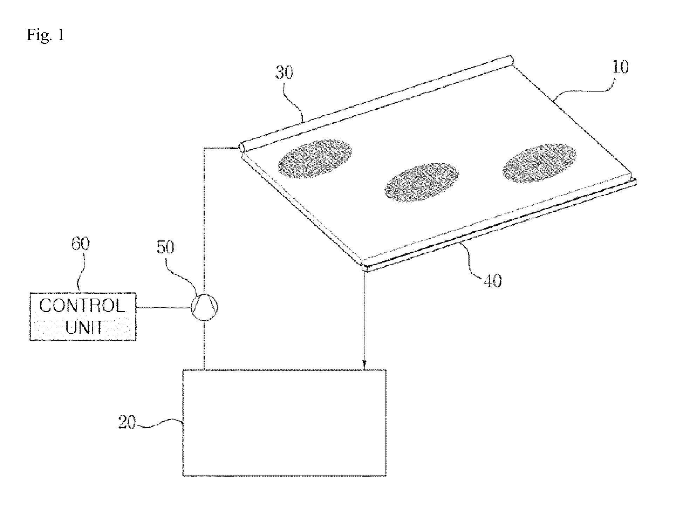

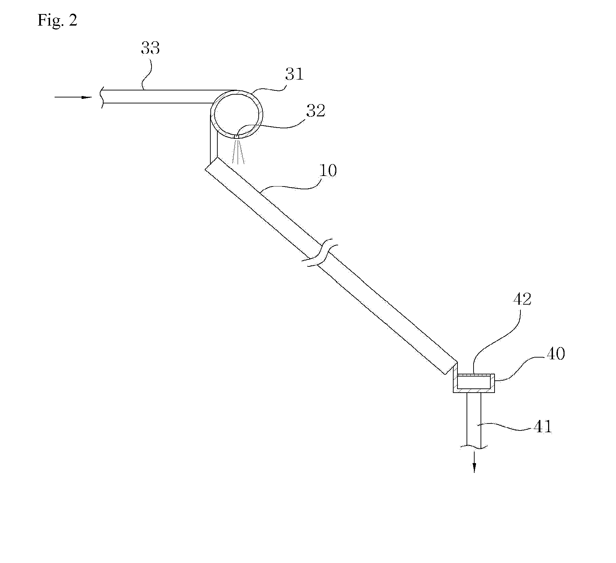

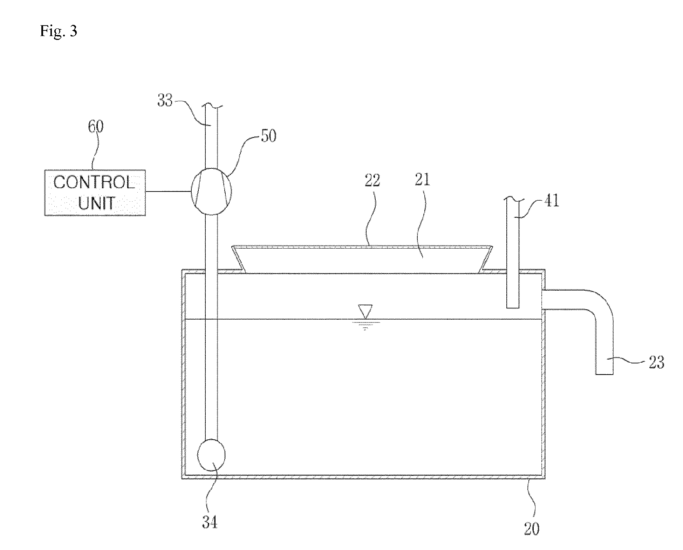

As illustrated in FIG. 1 to FIG. 3, a wash apparatus for a solar cell module according to the present invention includes a solar cell module 10, a desalination party 20, a watering party 30, a collection party 40 and a pump 50.

The solar cell module is a means, which receives solar energy supplied from sunlight and converts and converts it to electric energy to store it, and a conventional general technology.

The desalination party 20 is installed around the solar cell module, and is buried under the ground or is installed on the ground. It would be preferable that the desalination party is buried under the ground. A shape thereof may be changed according to a location or an environment to be installed.

Also, a catch pit 21 is installed in an upper part of the desalination party to enable rainwater to be stored. A filter 22 may be installed in the catch pit 21. The filter functions to prevent the water desalinated from the rainwater from being contaminated. Furthermore, it would be preferable for the filter to use a HEPA filter which may filter dust and the like. The HEPA filter may be installed to be detachable from the catch pit, even though this is not illustrated in the drawings.

Furthermore, a drain tube 23, which enables a water level of the desalinated water to be constantly maintained, may be installed in the desalination party. This is intended to prevent rainwater from overflowing from the desalination party at the time of desalinating the rainwater by maintaining the desalinated water so as not to be over a predetermined water level through the drain tube.

The watering party 30 is composed of: a watering tube 31 which is disposed at an upper end in a length direction of the solar cell module; a plurality of nozzles 32 which are open at a lower end of the watering tube 31 at regular intervals along a length direction of the watering tube; and a transfer tube 33 which supplies water from the desalination party 20 to the watering tube. The transfer tube 33 may include a filter 34. The filter is a means for filtering a pollution source from the desalinated water. It would be preferable for the filter to use the HEPA filter.

The collection party 40 is disposed at a lower end in a length direction of the solar cell module and functions to collect the water sparkled from the watering party and to move it to the desalination party.

Here, the collection party 40 may include a filter 42 for filtering and collecting the sparkled water.

The pump 50 is operated by receiving an electrical signal and is a means for circulating the desalinated water. Since it is the same as publicly known arts, the detailed explanation thereon will be omitted.

An operation state according to the present invention will be explained.

As previously described, the solar cell module is installed at the outdoor. The watering party 30 is installed at the upper end of the installed solar cell module, and the collection party 40 is installed at the lower end thereof.

The desalination party is buried on the ground or is installed or disposed on the ground, and is then connected to the watering party through a transfer tube 33 so that a circulation line is formed to a side of the disposed desalination party and the solar cell module. Furthermore, the collection party 40 is connected to the desalination party through an inflow tube 41.

The formed circulation line transfers the rainwater desalinated in the desalination party 20 to the watering tube 31 through the transfer tube 33 using the pump 50 so that water is sparkled on the surface of the solar cell module through the nozzle 32 of the watering tube, and foreign substances around the surface of the solar cell module are washed by the sparkled water, and the water is collected into the collection party 40 disposed at a lower side of the solar cell module.

Here, the filter 34 is disposed at the transfer tube 33 to prevent the entry of foreign substances from the desalinated water. Another filter (not drawn) is disposed at the collection party so that the foreign substances mixed into the water which washes the surface of the solar cell module are filtered, and the water is then collected into an inner part of the desalination party 20 through an inlet tube 41.

Meanwhile, as previously described, the desalination party desalinates rainwater primally and circulates it to wash the solar cell module. The desalination party is configured such that the rainwater is desalinated at an upper end of the desalination party through the catch pit. The filter is installed in the collection party so that foreign substances are not entered into the desalination party due to the rainwater.

Here, a cover is installed in the catch pit so that the catch pit can be covered with the cover in case of fine weather, and can open only in case of rain.

Also, the cover may open or close manually. However, the desalination party and the cover may be hinge-connected and may be driven by a motor or a cylinder, and thus as they are operated to open or close at close or long range, the efficiency of a work may be maximized.

Furthermore, a sensor for sensing rainwater is installed at the cover so that the rainwater can be sensed in case of rain, thereby enabling the cover to open.

Meanwhile, the control unit 60 may be electrically connected to the pump 50. The previously explained pump is operated by operating only a switch for a pump motion. However, when the control unit is connected to the pump, the pump may be operated by remote control at close or long range.

The control unit is composed of a micro computer and has a timer installed in an inner part thereof so that an operating time of the pump can be controlled by the timer, thereby enabling a washing time of the solar cell module to be controlled.

Also, the control unit and the pump are operated by energy generated from the solar cell module or a power source supplied from a storage battery in which electrical energy generated from the solar cell module is charged.

In particular, in the solar cell module and the desalination party, the solar cell panel which forms the solar cell module, and a frame which surrounds the solar cell panel so that a shape of the solar cell panel is maintained, may be coated with a hydrophilic inorganic material. Coating surfaces thereof are treated to be smooth, so it may be minimized that foreign substances are laminated on the coating surfaces. Furthermore, the surfaces are prevented from being damaged due to the foreign substances.

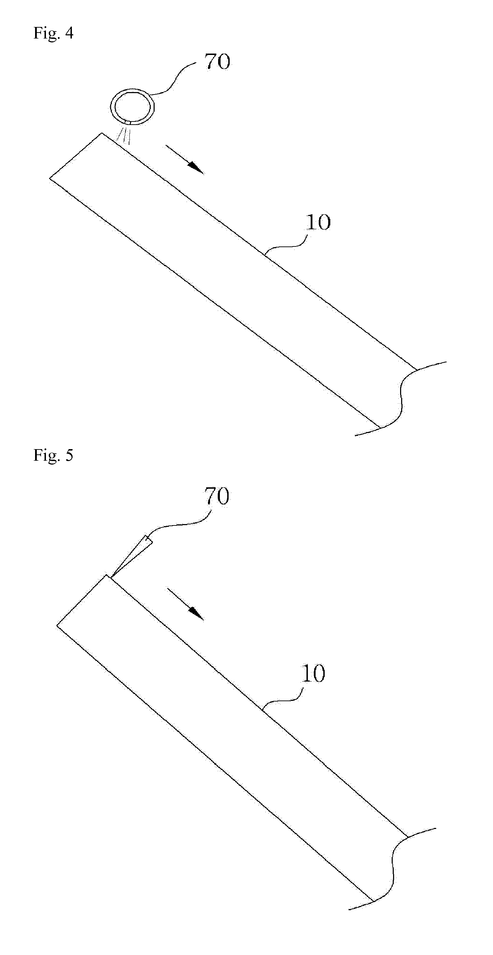

The solar cell module 10 of the present invention as illustrated in FIG. 4 and FIG. 5 may further include a removing means 70 for removing the sparkled water while moving from the upper end to the lower end. When the surface of the solar cell module is coated with the inorganic paint having an ultra hydrophilic characteristic, thanks to the hydrophilic characteristic, generation rate of remaining foreign substances or spots caused by the sparkled water is reduced compared to an existing glass. However, even through the generation rate is low, because light transmittance is reduced, photoelectric conversion efficiency may be reduced. Thus, the washing water should be completely removed so that efficiency can be maximized.

Here, the removing means 70 may remove the sparkled water by spraying compressed air through a nozzle or may remove the sparkled water using a wiper.

That is, as illustrated in FIG. 4, from a nozzle, which is open in a direction of the solar cell module along a length direction of the removing means installed lengthways in a length direction of an upper end of the solar cell module, compressed air is sprayed, and thus when the removing means is moved toward a lower side direction, water remained in the solar cell module can be completely removed. Furthermore, as illustrated in FIG. 5, a wiper shape is installed in a length direction of the solar cell module and moves from an upper direction to a lower direction to remove the water, thereby enabling efficiency of the solar cell module to be improved.

Also, the removing means as described above may remove water while moving from side to side.

Meanwhile, a means for moving the removing means may be driven by a motor or may be moved along an L/M guide. Furthermore, the means may be driven by a rack and a pinion which are driven by the motor or may be driven by various methods such as a cylinder. The means enables the removing means to move in up and down directions and includes all means which are driven in left and right directions.

For example, in case of rain, after desalinating rainwater by filtering it, the desalination party sparkles the water from the watering party onto the surface of the solar cell module through the pump and the control unit which are operated through a power source supplied from the solar cell module so that the solar cell module is washed. Then, the water remained in the washed solar cell module is removed by the removing means, and thereafter the washing water is again collected into the desalination party through filtering so that the water can be utilized. Thus, the water and energy which are necessary for washing the solar cell module can be autonomously settled, so a management cost for washing the solar cell module can be reduced.

Meanwhile, the surface of the solar cell module or the desalination party, or the surfaces of the solar cell module and the desalination party may be coated with the hydrophilic inorganic paint composition.

The hydrophilic inorganic paint composition includes: alkali metal silicate represented by formulas 1 to 3 below; phosphoric acid ($H_3PO_4$); one or more strong bases selected from the group consisting of KOH, NaOH, LiOH or LiOH-H2O; and water (H2O).

The alkali metal silicate included in the present invention is represented by formulas 1 to 3.

$$\text{[0066]} \qquad \text{[Formula 1] } xNa_2O \cdot ySiO_2 \cdot nH_2O$$

[Formula 2] $xK_2O \cdot ySiO_2 \cdot nH_2O$

[Formula 3] $xLi_2O \cdot ySiO_2 \cdot nH_2O$

In formulas 1 to 3 above, a ratio of x : y is 1 : 1.9 to 500, and n represents a natural number of 1 to 20.

As shown in formulas 1 to 3, the alkali metal silicate is composed of a complex compound. That is, it is a chemical species formed by combining some nonmetallic elements or atomic groups based on one or more elements such as Li, Na and K. This is a mechanism that an nonmetallic element is substituted to a central metal atom to make a single bond as a double bond, and thus a network structure is generated so that hydroxyl ion (-OH) attached to the silicate is substituted and dissociated to an ion due to a condensation reaction with the silicate, thereby preventing the penetration of water and improving water resistance.

It is characterized in that the alkali metal silicate represented by formulas 1 to 3 of the present invention is a liquid material, namely, $Na_2O \cdot ySiO_2 \cdot nH_2O$, $K_2O \cdot ySiO_2 \cdot nH_2O$, and $Na_2O \cdot ySiO_2 \cdot nH_2O$. At this time, a solid content included in the alkali metal silicate hydrate represented by formulas 1 to 3 may be 25% to 50%, 15% to 40%, and 10% to 35%. As the alkali metal silicate hydrate having the solid content in the ranges as described above is included, rapid and high reaction efficiency with other constitutive elements can be obtained at the time of production. Even after the production, in view of stability, it would be also preferable that the alkali metal silicate hydrate is included as described above.

Also, it is characterized in that the hydrophilic inorganic paint composition includes $Na_2O \cdot ySiO_2 \cdot nH_2O$, $K_2O \cdot ySiO_2 \cdot nH_2O$, and $Na_2O \cdot ySiO_2 \cdot nH_2O$ represented by formulas 1 to 3 above. As it includes all silicate hydrates of formulas 1 to 3 above, adhesive strength or adhesive power with a basic material is improved, and soil proof and corrosion resistance of the coating film are also improved.

The alkali metal silicate may be included in the range of 25 to 95 wt.% with respect to a total weight of the hydrophilic inorganic paint composition. When it is included in the range of less than 25 wt.%, in view of a capability for removing a pollutant of the coating film using the hydrophilic inorganic paint composition, hardness, and corrosion resistance, a preferred effect cannot be obtained. When it is included in the range of more than 95 wt.%, a problem relating to an adhesive property and adhesion with the solar cell module may be generated.

Moreover, the alkali metal silicate may be composed of 12 to 35 wt.% of $Na_2O \cdot ySiO_2 \cdot nH_2O$ represented by formula 1, 1 to 15 wt.% of $K_2O \cdot ySiO_2 \cdot nH_2O$ represented by formula 2, and 12 to 35 wt.% of $Na_2O \cdot ySiO_2 \cdot nH_2O$ represented by formula 3. When a composition ratio of formulas 1 to 3 which form the alkali metal silicate satisfies the ranges described above, with respect to strong coherence with the surface of the solar cell module, water resistance, soil proof, a high hardness capability, thermal resistance and the like, largely improved effects can be realized, and cracks and the like can be prevented from being generated.

The hydrophilic inorganic paint composition coated with the surface of the solar cell module of the present invention further includes phosphoric acid ($H_3PO_4$). When the hydrophilic inorganic paint composition forms a coating film on the surface of the solar cell module with, the phosphoric acid ($H_3PO_4$) provides an effect that a hydrophilic characteristic is improved by increasing a contact angle between the water and the coating film. The hydrophilic inorganic paint composition may include the phosphoric acid ($H_3PO_4$) in the range of 0.1 to 1 wt.%. When the phosphoric acid ($H_3PO_4$) is beyond the range, it would be difficult to obtain the effect which is intended by the existence of the phosphoric acid ($H_3PO_4$).

The hydrophilic inorganic paint composition of the present invention further includes one or more strong bases selected from the group consisting of KOH, NaOH, LiOH or LiOH. H2O. The strong bases may be included in the range of 0.5 to 5 wt.% with respect to the total weight of the inorganic paint composition. More preferably, the strong bases may be included in the range of 1 to 3 wt.%. According to the preferred contents, when the strong bases is included in the inorganic paint composition, high reaction efficiency of the composition can be obtained, and application of the finally produced inorganic paint composition can be improved. Furthermore, when the composition is produced, a hardening phenomenon can be prevented from being generated. Also, because the composition is produced so as to have a pH of 8 to 14, desirable reaction efficiency can be obtained, and the composition can be maintained in an optimum solution state.

A hydrophilic solvent like water as a solvent in which components are combined by the composition ratio may be used for the hydrophilic inorganic paint composition of the present invention. The representative water among the hydrophilic solvents may be included in the range of 4 to 74 wt.% with respect to the total weight of the inorganic paint composition. The water, which works as a solvent, enables dispersibility and reaction efficiency of the alkali metal silicate to be improved.

Furthermore, a pigment for providing colors to the coating film, and an additive for improving flexibility, an adhesive property, shock resistance and smoothness of the coating film may be further added to the inorganic paint composition.

One or more materials selected from the group consisting of ethylene glycol, diethylene glycol, aluminum stearate, silica, zirconium silicate, calcium silicate, alkyl sulfonate metallic salts, polysiloxane denaturants, and silane may be used as the additive. The additive is used in the range of 0.1 to 2 wt.% with respect to the total weight of the inorganic paint composition, thereby enabling a desired effect to be realized.

A method of forming the coating film on the surfaces of the solar cell module and the desalination party using the hydrophilic inorganic paint composition is not specifically limited. Various methods may be used. However, preferably, the coating film may be formed according to one exemplary method as described below.

a) The hydrophilic inorganic paint composition according to the present invention is first produced by mixing the alkali metal silicate represented by the following formulas 1 to 3, phosphoric acid ($H_3PO_4$), one or more strong bases selected from the group consisting of KOH, NaOH, LiOH or $LiOH \cdot H2O$, water ($H2O$), and other additives within the ranges of the composition in a state of putting in an agitator. At this time, it would be preferable that an agitating speed is 150~400RPM. When the agitating speed is less than 150 RPM, the compositions are not sufficiently mixed. This is because there is no large difference in agitating capability, even through the agitating speed exceeds 400RPM.

The inorganic paint composition of the present invention may be produced by injecting and agitating the component substances of the inorganic paint composition at a time. However, the inorganic paint composition may be produced by separately producing two or more compositions, and thereafter agitating them again.

That is, the inorganic paint composition of the present invention may be produced by first producing a first composition including the phosphoric acid ($H_3PO_4$), the strong bases and the water ($H_2O$), and a second composition including the alkali metal silicate represented by formulas 1 to 3, the strong bases and the water ($H_2O$), respectively, and mixing and agitating the first composition and the second composition in the ratio of 1:1. When the inorganic paint composition is produced in such a way, it is coated with the surface of a solar cell, thereby improving a cleaning capability.

At this time, the phosphoric acid ($H_3PO_4$) included in the first composition may be include in the range of 0.05 to 1 wt.% with respect to the total weight of the inorganic paint composition, and the strong bases of 0.05 to 1 wt.% and distilled water of 2 to 50 wt.% may be included.

The alkali metal silicate included in the second composition and represented by formulas 1 to 3 may be included in the range of 42 to 95 wt.%, and the strong bases of 0.05 to 1 wt.%, and the distilled water of 2 to 24 wt.% may be included. Also, as described above, when the inorganic paint composition is produced, the pH should maintained in a state of 8 to 14 so that desired reaction efficiency can be obtained, and the composition can be maintained in an optimum solution state.

b) After the hydrophilic inorganic paint composition is produced, a step of pre-heating a glass plate for the solar cell module at a predetermined temperature may be included.

The preheat temperature may be about $50 \pm 10°C$. Thanks to this step, the surface of the solar cell module may be efficiently coated with the hydrophilic inorganic paint composition.

Also, before performing the preheating treatment, for hydrophilicity of the glass surface of the solar cell module, a step of pre-processing the surface using any one method among methods such as plasma, anodizing, sanding, and etching processes of removing foreign substances from the surface by degreasing and washing the surface is further included, so that the surface of the solar cell module can be protected, and formation of the inorganic coating film can be efficiently performed.

In an ultrasonic washing step which can be used as a step of washing the surface, washing may be performed in such a manner that a surface material for the solar cell module is immersed in an ultrasonic tank in which a water-soluble cleaning agent is filled, and thereafter ultrasonic waves are generated so that even minute parts outside the surface material can be washed. The ultrasonic waves may be 28 to 48 kHZ. In the ultrasonic washing step, the water-soluble cleaning agent including inorganic salt is used. When the water-soluble cleaning agent including the inorganic salt is used, stickiness with the inorganic coating film, which is a coating film formed on the surface of the basic material, can be improved, and a coating film having high hardness can be also formed.

c) When surface treatment and preheating treatment for the surface of the solar cell module are finished by the above step, a step of coating the surface of the solar cell module with the hydrophilic inorganic paint composition is performed. At this time, the coating method is not specifically limited. Publicly known methods may be used. For example, the surface of the solar cell module may be coated with the hydrophilic inorganic paint composition using any one method of a dipping coating method, a spray coating method, a roll coating method, a spin coating method, a bar coating method, a flow coating method, a curtain coating method, a knife coating method, a vacuum deposition method, an ion plating method, a plasma deposition method and the like.

At this time, the coating film of the inorganic paint composition coated with the surface of a basic material may have a coating thickness of 0.01 to 30 $\mu$m. However, with regard to all coating methods as described above, the coating thickness can be controlled according to a size, a shape and the like of the solar cell module. According to circumstances, the coating step may be performed by the same methods several times to form the coating film.

d) After the hydrophilic inorganic paint composition is coated on the surface of the solar cell module through the above step, to completely harden the coating film, a plastic step is performed for a predetermined time. At this time, when the plastic step is performed for 30 minutes to 3 hours at a temperature of 80°C to 450°C, it would be preferable to realize a soft surface and hardness of the coating film at the same time as not having a large effect on the solar cell module itself.

The plastic step may be performed in a state of being divided into sub-steps such as a first plastic process, a second plastic process and a cooling process. Specifically, when a temperature reaches a first plastic temperature, the temperature is maintained not to increase, and the internal temperature of a kiln is maintained to the first plastic temperature, so the first plastic process is performed for a predetermined time. At this time, it would be preferable that the first plastic temperature is $80\pm60°C$.

Of course, an auxiliary plastic step for an auxiliary plastic process may be further performed by uniformly maintaining the temperature for 10 or more minutes under the lower temperature than the first plastic temperature.

Furthermore, when the first plastic process is completed and the temperature reaches a second plastic temperature, the temperature is maintained not to increase, and the internal temperature of the kiln is maintained to the second plastic temperature, so the second plastic process is performed for a predetermined time. At this time, it would be preferable that the second plastic temperature is $250\pm50\square$ to $400\pm90\square$.

Also, an auxiliary plastic step for an auxiliary plastic process may be further performed by uniformly maintaining the temperature for 10 or more minutes under the temperature between the first plastic temperature and the second plastic temperature.

Thus, when the first and second plastic processes are completed, the cooling process for cooling the solar cell module to room temperature is performed. The cooling process is a process for reducing the temperature of the solar cell module to the room temperature. At this time, like the first and second plastic processes, the cooling process may be performed in such a manner that the temperature is reduced until it becomes a predetermined temperature, and the predetermined temperature is maintained for a predetermined time, and then is again reduced.

Additionally, before performing the plastic step, a step of drying the solar cell module coated with the hydrophilic inorganic paint composition at room temperature may be further performed. For example, for double side coating at the time of spray coating, after coating on one side, it is dried for a predetermined time, and thereafter a drying step for coating on another side may be further included. When forming a coating film, the coating film having improved productivity and an optimum condition according to application objects may be formed by controlling temperatures and times depending on the amount of water ($H_2O$) included in the coating composition.

According to the methods described above, polluted materials on the surface of the solar cell module having the coating film formed using the hydrophilic inorganic paint composition can be easily removed. Furthermore, almost all polluted materials can be removed by only an action, which is performed so that water flows, without applying other apparatuses or physical actions. Moreover, the coating film is effective to improve a capability of the solar cell module. Specifically, thanks to the coating film, reflectance and transmittance of the solar cell module can be improved, and the efficiency of solar cells can be also largely improved.

Hereinafter, an example and a comparative example concerning the present invention will be explained.

**Example**

An inorganic paint composition was produced by mixing and agitating 40 parts by weight of $Na_2O\cdot ySiO_2\cdot nH_2O$ and 5 parts by weight of $K_2O\cdot ySiO2\cdot nH2O$, which are produced by Daejung Chemicals & Metals Co., Ltd., 20 parts by weight of Na2O·ySiO2·nH2O produced by Young Il Chemical Co., Ltd., 0.25 parts by weight of phosphoric acid ($H_3PO_4$), 0.5 parts by weight of NaOH, 0.005 parts by weight of Poly-oxyethylene Sorbitan Monostearate as an additive, and 34.2 parts by weight of water. Furthermore, a coating film was formed by coating a mini sample for a solar cell module, in which the Motech 6" cell is modulated (2X1), with the inorganic paint composition. A rear surface part thereof used the white B/S.

**Comparative Example**

Except for the matter that the mini sample for the solar cell module is not coated with the inorganic paint composition, the mini sample of the comparative example was made under the same conditions as those of Example above.

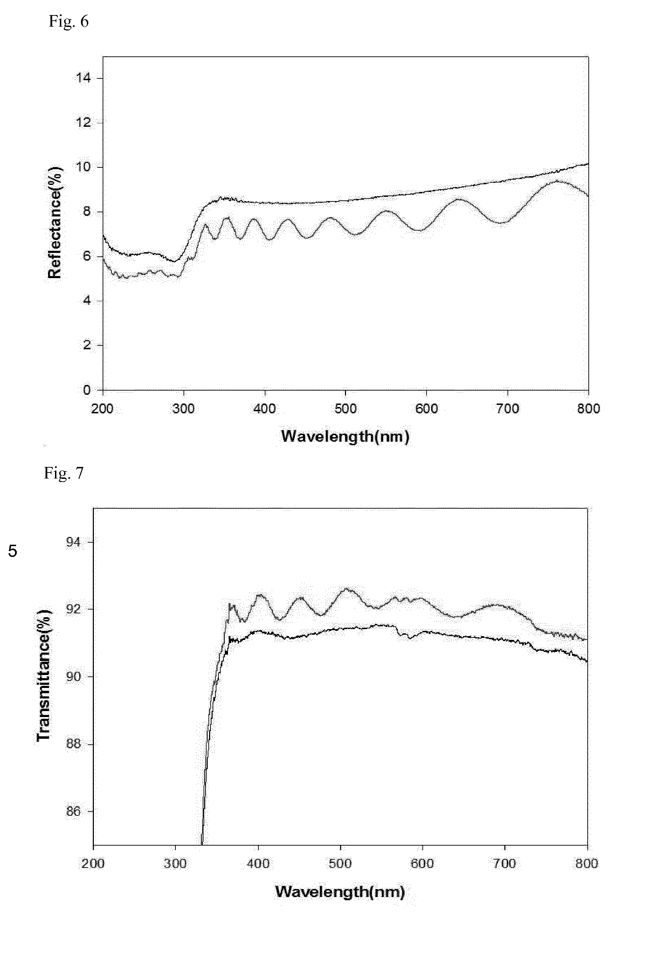

After exposing the samples in the example and the comparative example to ultraviolet rays for 60 minutes at 60°C using equipment of Lichtzen Company, a variation in outputs was measured by irradiating the energy of 1000W/m2 at 25°C using spire equipment, and reflectance and transmittance with respect to light having wavelengths of 400nm and 600nm were compared and measured. Thus, the results are described in Table 1, FIG. 6, and FIG. 7.

[Table 1]

| | Comparison of outputs before the samples are exposed to ultraviolet rays | Comparison of outputs after the sample are exposed to ultraviolet rays |
|---|---|---|
| Example | 7.564 (Wp) | 7.595 (Wp) |
| Comparative Example | 7.121 (Wp) | 7.121 (Wp) |
| Output Improvement Ratio | 6.2% | 6.7% |

Referring to Table 1 above, the module according to the present exemplary embodiment of the invention shows 6% or more output improvement before and after the samples are exposed to ultraviolet rays compared to that of the comparative example. Even though it is considered that the module is the mini module and there is an error of measurement environments (temperatures), it could be confirmed that the output is largely improved.

Also, referring to FIG. 6 and FIG. 7, it could be confirmed that the solar cell module (red rays) according to the present invention has largely improved reflectance and transmission compared to the solar cell module (black rays) in which the coating film is not formed. Thus, it is expected that efficiency of the solar cell will be largely increased. Specifically, thanks to the coating film, the optical transmittance of the solar cell module was increased up to about 1~2%, and at the same time, the reflectance was reduced up to about 2%. Thus, the effect that the output of the solar cell module is increased up to about 6% or more was generated.

As previously described, in the detailed description of the invention, having described the detailed exemplary embodiments of the invention, it should be apparent that modifications and variations can be made by persons skilled without deviating from the spirit or scope of the invention. Therefore, it is to be understood that the foregoing is illustrative of the present invention and is not to be construed as limited to the specific embodiments disclosed, and that modifications to the disclosed embodiments, as well as other embodiments, are intended to be included within the scope of the appended claims and their equivalents.

**Claims**

1. A washing apparatus for a solar cell module, comprising:

    a solar cell module which obtains solar energy from sunlight;
    a watering party which is disposed at an upper end of the solar cell module to sparkle water;
    a collection party which is disposed at a lower end of the solar cell module to collect the water sparkled from the watering party;
    a desalination party which desalinates the water collected by the collection party or desalinates rainwater through a catch pit; and
    a pump which circulates the desalinated water.

2. The washing apparatus of claim 1, wherein the pump comprises a control unit for controlling an operation of the pump.

3. The washing apparatus of claim 2, wherein the pump and the control unit are operated by a power source supplied from the solar cell module.

4. The washing apparatus of claim 2, wherein the pump and the control unit are operated by a power source supplied from a storage battery.

5. The washing apparatus of claim 3 or claim 4, wherein the control unit controls an operating time of the pump.

6. The washing apparatus of claim 1, wherein the desalination party comprises a drain tube which enables the desalinated water to have a predetermined water level.

7. The washing apparatus of claim 1, wherein the catch pit comprises a filter for removing a pollution source from rainwater.

8. The washing apparatus of claim 1, wherein the desalination party is provided with another filter for filtering water.

9. The washing apparatus of claim 1, wherein the solar cell module further comprises a removing means for removing the desalinated water while moving from an upper end to a lower end or moving in right and left directions.

10. The washing apparatus of claim 9, wherein the removing means removes the sparkled water by spraying compressed air through a nozzle.

11. The washing apparatus of claim 9, wherein the removing means removes the sparked water using a wiper.

12. The washing apparatus of claim 1, wherein a surface of the solar cell module is coated with a hydrophilic inorganic paint composition, and the hydrophilic inorganic paint composition comprises: alkali metal silicate represented by formulas 1 to 3 below; phosphoric acid ($H_3PO_4$); one or more strong bases selected from the group consisting of KOH, NaOH, LiOH or LiOH·H2O; and water (H2O),

$$[\text{Formula 1}] \ xNa_2O \cdot ySiO_2 \cdot nH_2O$$

$$[\text{Formula 2}] \ xK_2O \cdot ySiO_2 \cdot nH_2O$$

$$[\text{Formula 3}] \ xLi_2O \cdot ySiO_2 \cdot nH_2O$$

wherein a ratio of x and y is 1 : 1.9 to 500, and n represents a natural number of 1 to 20.

13. The washing apparatus of claim 12, wherein the hydrophilic inorganic paint composition comprises: 25 to 95 wt.% of the alkali metal silicate represented by formulas 1 to 3 above; 0.1 to 1 wt.% of the phosphoric acid ($H_3PO_4$), 0.5 to 5 wt.% of the strong bases; and 4 to 74 wt.% of the water ($H_2O$) with respect to a total weight thereof.

14. The washing apparatus of claim 13, wherein the alkali metal silicate represented by formulas 1 to 3 above is included in the range of 12 to 35 wt.%, 1 to 15 wt.%, and 12 to 35 wt.% respectively with respect to the total weight of the inorganic paint composition.

Fig. 1

Fig. 2

Fig. 3

Fig. 4

70

10

Fig. 5

70

10

Fig. 6

Fig. 7